# EUROPEAN PATENT SPECIFICATION

(11) **EP 1 359 455 B1**
(45) Date of publication and mention of the grant of the patent: **21.06.2006**
(21) Application number: 03252590.9
(22) Date of filing: 24.04.2003
(51) Int. Cl.: G02B 26/08, B81B 3/00

(54) **Micro-mirror device**
Mikrospiegel-Vorrichtung
Dispositif à micro-miroir

(30) Priority: 30.04.2002 US 136719
(43) Date of publication of application: 05.11.2003
(73) Proprietor: Hewlett-Packard Company, Palo Alto, CA 94304 (US)
(72) Inventor: Weber, Timothy L., Corvallis, OR 97330 (US); Radominski, George, Corvallis, OR 97330 (US); Johnson, Norman L., Corvallis, OR 97330 (US); McMahon, Terry E., Corvallis, OR 97330 (US); Schulte, Donald W., Corvallis, OR 97330 (US); Donaldson, Jeremy H., Corvallis, OR 97333 (US); Rosi, Leonard A., Philomath, OR 97370 (US); Bengali, Sadiq S., Corvallis, OR 97330 (US)
(74) Representative: Jackson, Richard Eric

(56) References cited:
- EP-A- 0 916 984
- WO-A-02/10836
- US-A- 4 359 698

## Description

### The Field of the Invention

The present invention relates generally to micro-actuators, and more particularly to a micro-mirror device.

### Background of the Invention

Micro-actuators have been formed on insulators or other substrates using micro-electronic techniques such as photolithography, vapor deposition, and etching. Such micro-actuators are often referred to as micro-electromechanical systems (MEMS) devices. An example of a micro-actuator includes a micro-mirror device. The micro-mirror device can be operated as a light modulator for amplitude and/or phase modulation of incident light. One application of a micro-mirror device is in a display system. As such, multiple micro-mirror devices are arranged in an array such that each micro-mirror device provides one cell or pixel of the display.

A conventional micro-mirror device includes an electrostatically actuated mirror supported for rotation about an axis of the mirror. Conventional micro-mirror devices, however, must be sufficiently sized to permit rotation of the mirror relative to supporting structure. Increasing the size of the micro-mirror device, however, reduces resolution of the display since fewer micro-mirror devices can occupy a given area. In addition, applied activation energies must be sufficiently large to generate a desired activation force on the minor.

US 4,359,698 discloses a reflective type light modulator which uses the principal of ion injection from a switching electrode into a fluid dielectric to effect turbulent forces and the resultant movement of a light reflecting object into and out of a light path.

EP 0 916 984 A1 discloses a light deflection device comprising a deflection member having a segmental spherical body enclosing a deflection face portion for deflecting a light beam, a supporting member for supporting the deflection member in a turnable manner, and a driving means for turning the deflection member, the driving means being provided on the segmental spherical face.

Accordingly, it is desired to minimize a size of a micro-mirror device so as to maximize the density of an array of such devices as well as increase an activation force on the micro-mirror device as generated by a given activation energy.

### Summary of the Invention

The present invention provides an electrostatically actuated micro-mirror device and a method of forming an electrostatically actuated micro-mirror device as recited in the claims.

### Brief Description of the Drawings

Figure 1 is a schematic cross-sectional view illustrating one embodiment of a portion of a micro-mirror device according to the present invention.
Figure 2 is a perspective view illustrating one embodiment of a portion of a micro-mirror device according to the present invention.
Figure 3 is a perspective view illustrating another embodiment of a portion of a micro-mirror device according to the present invention.
Figure 4 is a schematic cross-sectional view taken along line 4-4 of Figures 2 and 3 illustrating one embodiment of actuation of the micro-mirror device according to the present invention.
Figure 5 is a schematic cross-sectional view similar to Figure 4 illustrating another embodiment of actuation of the micro-mirror device according to the present invention.
Figure 6 is a schematic cross-sectional view similar to Figure 4 illustrating another embodiment of actuation of the micro-mirror device according to the present invention.
Figure 7 is a perspective view illustrating another embodiment of a portion of a micro-mirror device according to the present invention.
Figure 8 is a schematic cross-sectional view taken along line 8-8 of Figure 7 illustrating one embodiment of actuation of the micro-mirror device according to the present invention.
Figure 9 is a perspective view illustrating another embodiment of a portion of a micro-mirror device according to the present invention.
Figure 10A is a schematic cross-sectional view taken along line 10-10 of Figure 9 illustrating one embodiment of actuation of the micro-mirror device according to the present invention.
Figure 10B is a schematic cross-sectional view similar to Figure 10A illustrating actuation of another embodiment of a micro-mirror device according to the present invention.
Figure 10C is a schematic cross-sectional view similar to Figure 10A illustrating actuation of another embodiment of a micro-mirror device according to the present invention.
Figure 11 is a perspective view illustrating another embodiment of a portion of a micro-mirror device according to the present invention.
Figure 12 is a schematic cross-sectional view taken along line 12-12 of Figure 11 illustrating one embodiment of actuation of the micro-mirror device according to the present invention.
Figure 13 is a block diagram illustrating one embodiment of a display system including a micro-mirror device according to the present invention.
Figure 14 is a perspective view illustrating one embodiment of a portion of an array of micro-mirror devices according to the present invention.
Figure 15 is a perspective view illustrating another embodiment of a portion of an array of micro-mirror devices according to the present invention.

### Description of the Preferred Embodiments

In the following detailed description of the preferred embodiments, reference is made to the accompanying drawings which form a part hereof, and in which is shown by way of illustration specific embodiments in which the invention may be practiced. In this regard, directional terminology, such as "top," "bottom," "front," "back," "leading," "trailing," etc., is used with reference to the orientation of the Figure(s) being described. Because components of the present invention can be positioned in a number of different orientations, the directional terminology is used for purposes of illustration and is in no way limiting. It is to be understood that other embodiments may be utilized and structural or logical changes may be made without departing from the scope of the present invention. The following detailed description, therefore, is not to be taken in a limiting sense, and the scope of the present invention is defined by the appended claims.

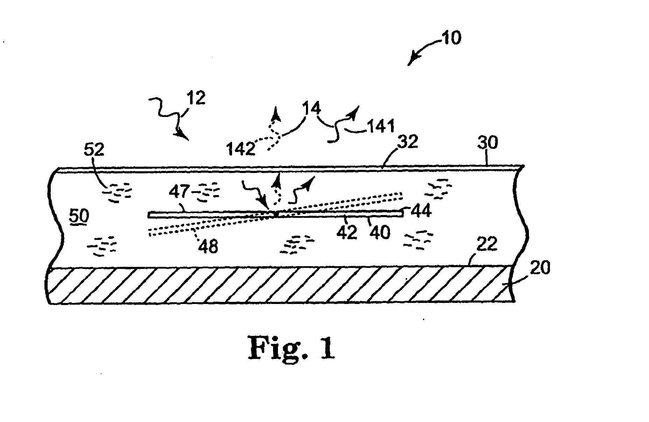

Figure 1 illustrates one embodiment of a micro-mirror device 10. Micro-mirror device 10 is a micro-actuator which relies on electrical to mechanical conversion to generate a force and cause movement or actuation of a body or element. In one embodiment, as described below, a plurality of micro-mirror devices 10 are arranged to form an array of micro-mirror devices. As such, the array of micro-mirror devices may be used to form a display. As such, each micro-mirror device 10 constitutes a light modulator for modulation of incident light and provides one cell or pixel of the display. In addition, micro-mirror device 10 may also be used in other imaging systems such as projectors and may also be used for optical addressing.

In one embodiment, micro-mirror device 10 includes a substrate 20, a plate 30, and an actuating element 40. Substrate 20 has a surface 22. In one embodiment, surface 22 is formed by a trench or tub formed in and/or on substrate 20. Preferably, plate 30 is oriented substantially parallel to surface 22 and spaced from surface 22 so as to define a cavity 50 therebetween. Actuating element 40 is interposed between surface 22 of substrate 20 and plate 30. As such, actuating element 40 is positioned within cavity 50.

In one embodiment, actuating element 40 is actuated so as to move between a first position 47 and a second position 48 relative to substrate 20 and plate 30. Preferably, actuating element 40 moves or tilts at an angle about an axis of rotation. As such, first position 47 of actuating element 40 is illustrated as being substantially horizontal and substantially parallel to substrate 20 and second position 48 of actuating element 40 is illustrated as being oriented at an angle to first position 47. Movement or actuation of actuating element 40 relative to substrate 20 and plate 30 is described in detail below.

In one embodiment, cavity 50 is filled with a dielectric liquid 52 such that actuating element 40 is in contact with dielectric liquid 52. In one embodiment, cavity 50 is filled with dielectric liquid 52 such that actuating element 40 is submerged in dielectric liquid 52. Dielectric liquid 52, therefore, is disposed between actuating element 40 and substrate 20 and between actuating element 40 and plate 30. Thus, dielectric liquid 52 contacts or wets opposite surfaces of actuating element 40. In another embodiment, cavity 50 is filled with dielectric liquid 52 such that actuating element 40 is positioned above dielectric liquid 52 and at least a surface of actuating element 40 facing substrate 20 is in contact with dielectric liquid 52. Dielectric liquid 52 enhances actuation of actuating element 40, as described below.

Preferably, dielectric liquid 52 is transparent. As such, dielectric liquid 52 is clear or colorless in the visible spectrum. In addition, dielectric liquid 52 is chemically stable in electric fields, chemically stable with changes in temperature, and chemically inert. In addition, dielectric liquid 52 has a low vapor pressure and is non-corrosive. Furthermore, dielectric liquid 52 has a high molecular orientation in electric fields and moves in an electric field.

Preferably, dielectric liquid 52 has a low dielectric constant and a high dipole moment. In addition, dielectric liquid 52 is generally flexible and has pi electrons available. Examples of liquids suitable for use as dielectric liquid 52 include phenyl-ethers, either alone or in blends (i.e., 2, 3, and 5 ring), phenly-sulphides, and/or phenly-selenides. In one illustrative embodiment, examples of liquids suitable for use as dielectric liquid 52 include a polyphenyl ether (PPE) such as OS138 and olive oil.

Preferably, plate 30 is a transparent plate 32 and actuating element 40 is a reflective element 42. In one embodiment, transparent plate 32 is a glass plate. Other suitable planar translucent or transparent materials, however, may be used. Examples of such a material include quartz and plastic.

Reflective element 42 includes a reflective surface 44. In one embodiment, reflective element 42 is formed of a uniform material having a suitable reflectivity to form reflective surface 44. Examples of such a material include a metal such as aluminum. In another embodiment, reflective element 42 is formed of a base material such as polysilicon with a reflective material such as aluminum disposed on the base material to form reflective surface 44. In addition, reflective element 42 may be formed of or include a conductive material.

As illustrated in the embodiment of Figure 1, micro-mirror device 10 modulates light generated by a light source (not shown) located on a side of transparent plate 32 opposite of substrate 20. The light source may include, for example, ambient and/or artificial light. As such, input light 12, incident on transparent plate 32, passes through transparent plate 32 into cavity 50 and is reflected by reflective surface 44 of reflective element 42 as output light 14. Thus, output light 14 passes out of cavity 50 and back through transparent plate 32.

The direction of output light 14 is determined or controlled by the position of reflective element 42. For example, with reflective element 42 in first position 47, output light 14 is directed in a first direction 141. However, with reflective element 42 in second position 48, output light 14 is directed in a second direction 142. Thus, micro-mirror device 10 modulates or varies the direction of output light 14 generated by input light 12. As such, reflective element 42 can be used to steer light into, and/or away from, an optical imaging system.

In one embodiment, first position 47 is a neutral position of reflective element 42 and represents an "ON" state of micro-mirror device 10 in that light is reflected, for example, to a viewer or onto a display screen, as described below. Thus, second position 48 is an actuated position of reflective element 42 and represents an "OFF" state of micro-mirror device 10 in that light is not reflected, for example, to a viewer or onto a display screen.

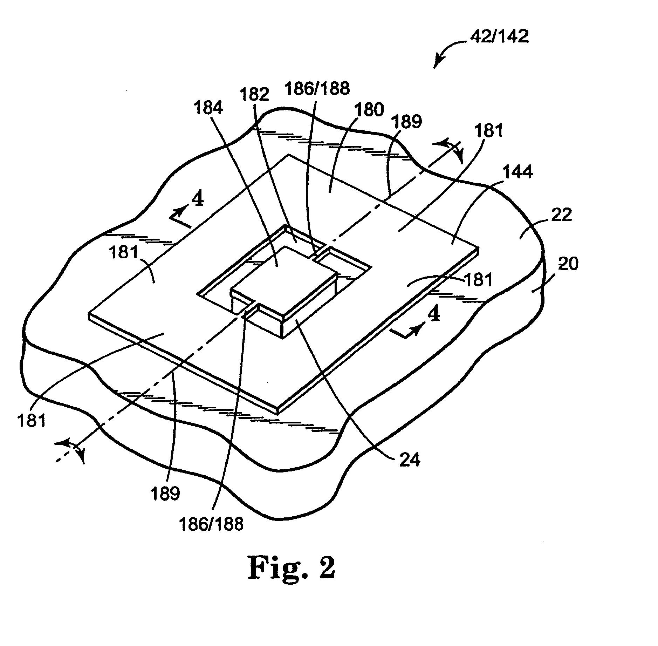

Figure 2 illustrates one embodiment of reflective element 42. Reflective element 142 has a reflective surface 144 and includes a substantially rectangular-shaped outer portion 180 and a substantially rectangular-shaped inner portion 184. In one embodiment, reflective surface 144 is formed on both outer portion 180 and inner portion 184. Outer portion 180 has four contiguous side portions 181 arranged to form a substantially rectangular-shaped opening 182. As such, inner portion 184 is positioned within opening 182. Preferably, inner portion 184 is positioned symmetrically within opening 182.

In one embodiment, a pair of hinges 186 extend between inner portion 184 and outer portion 180. Hinges 186 extend from opposite sides or edges of inner portion 184 to adjacent opposite sides or edges of outer portion 180. Preferably, outer portion 180 is supported by hinges 186 along an axis of symmetry. More specifically, outer portion 180 is supported about an axis that extends through the middle of opposed edges thereof. As such, hinges 186 facilitate movement of reflective element 142 between first position 47 and second position 48, as described above (Figure 1). More specifically, hinges 186 facilitate movement of outer portion 180 between first position 47 and second position 48 relative to inner portion 184.

In one embodiment, hinges 186 include torsional members 188 having longitudinal axes 189 oriented substantially parallel to reflective surface 144. Longitudinal axes 189 are collinear and coincide with an axis of symmetry of reflective element 142. As such, torsional members 188 twist or turn about longitudinal axes 189 to accommodate movement of outer portion 180 between first position 47 and second position 48 relative to inner portion 184.

In one embodiment, reflective element 142 is supported relative to substrate 20 by a support or post 24 extending from surface 22 of substrate 20.
More specifically, post 24 supports inner portion 184 of reflective element 142. As such, post 24 is positioned within side portions 181 of outer portion 180. Thus, outer portion 180 of reflective element 142 is supported from post 24 by hinges 186.

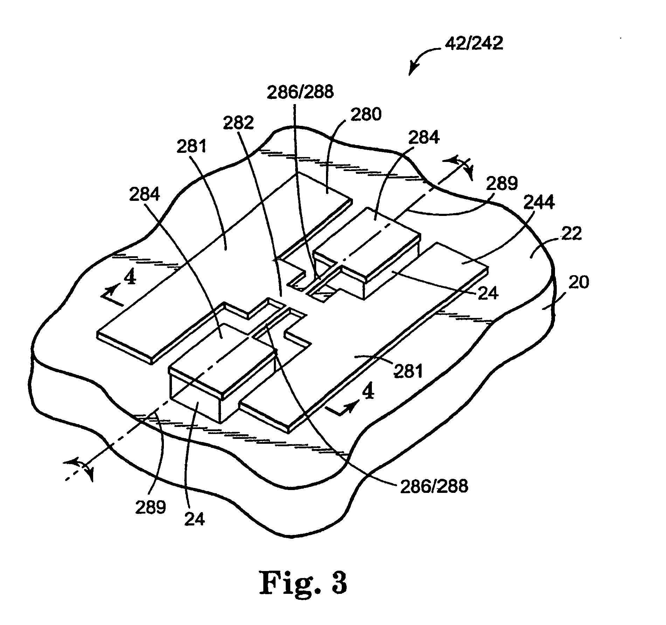

Figure 3 illustrates another embodiment of reflective element 42. Reflective element 242 has a reflective surface 244 and includes a substantially H-shaped portion 280 and a pair of substantially rectangular-shaped portions 284. In one embodiment, reflective surface 244 is formed on both H-shaped portion 280 and rectangular-shaped portions 284. H-shaped portion 280 has a pair of spaced leg portions 281 and a connecting portion 282 extending between spaced leg portions 281. As such, rectangular-shaped portions 284 are positioned on opposite sides of connection portion 282 between spaced leg portions 281. Preferably, rectangular-shaped portions 284 are positioned symmetrically to spaced leg portions 281 and connecting portion 282.

In one embodiment, hinges 286 extend between rectangular-shaped portions 284 and H-shaped portion 280. Hinges 286 extend from a side or edge of rectangular-shaped portions 284 to adjacent opposite sides or edges of connecting portion 282 of H-shaped portion 280. Preferably, H-shaped portion 280 is supported by hinges 286 along an axis of symmetry. More specifically, H-shaped portion 280 is supported about an axis that extends through the middle of opposed edges of connecting portion 282. As such, hinges 286 facilitate movement of reflective element 242 between first position 47 and second position 48, as described above (Figure 1). More specifically, hinges 286 facilitate movement of H-shaped portion 280 between first position 47 and second position 48 relative to rectangular-shaped portions 284.

In one embodiment, hinges 286 include torsional members 288 having longitudinal axes 289 oriented substantially parallel to reflective surface 244. Longitudinal axes 289 are collinear and coincide with an axis of symmetry of reflective element 242. As such, torsional members 288 twist or turn about longitudinal axes 289 to accommodate movement of H-shaped portion 280 between first position 47 and second position 48 relative to rectangular-shaped portions 284.

In one embodiment, reflective element 242 is supported relative to substrate 20 by a pair of posts 24 extending from surface 22 of substrate 20. More specifically, posts 24 support rectangular-shaped portions 284 of reflective element 242. As such, posts 24 are positioned on opposite sides of connecting portion 282 between spaced leg portions 281. Thus, H-shaped portion 280 of reflective element 242 is supported from posts 24 by hinges 286.

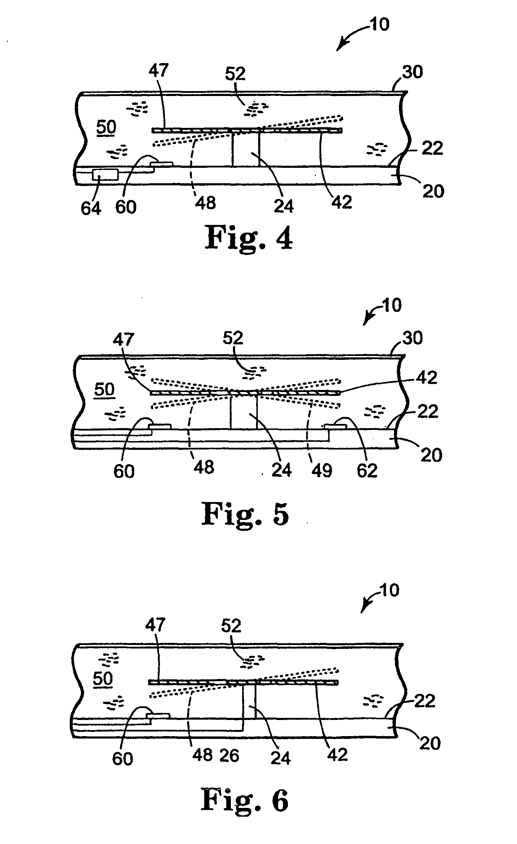

Figure 4 illustrates one embodiment of actuation of micro-mirror device 10. In one embodiment, reflective element 42 (including reflective elements 142 and 242) is moved between first position 47 and second position 48 by applying an electrical signal to an electrode 60 formed on substrate 20. Preferably, electrode 60 is formed on substrate 20 adjacent an end or edge of reflective element 42. Application of an electrical signal to electrode 60 generates an electric field between electrode 60 and reflective element 42 which causes movement of reflective element 42 between first position 47 and second position 48. In one embodiment, the electrical signal is applied to electrode 60 by drive circuitry 64.

Dielectric liquid 52 is selected so as to respond to the electric field. More specifically, dielectric liquid 52 is selected such that the electric field aligns and moves polar molecules of the liquid. As such, dielectric liquid 52 moves in the electric field and contributes to the movement of reflective element 42 between first position 47 and second position 48 upon application of the electrical signal. Thus, with dielectric liquid 52 in cavity 50, dielectric liquid 52 enhances an actuation force acting on reflective element 42. More specifically, dielectric liquid 52 increases an actuation force on reflective element 42 as generated by a given activation energy. In addition, dielectric liquid 52 provides thermal management and/or cooling properties by dissipating heat developed within or absorbed by micro-mirror device 10. Heat may be developed within micro-mirror device 10 by movement of reflective element 42 and/or heat may be absorbed by micro-mirror device 10 by light impinged on reflective element 42.

By enhancing the actuation force acting on reflective element 42, dielectric liquid 52 allows lower activation energies to be applied for actuation of reflective element 42. For example, activation energies less than approximately 10 volts can be used.

Because lower activation voltages can be used, drive circuitry 64 for micro-mirror device 10 can be incorporated into substrate 20. Thus, complimentary metal oxide semi-conductor (CMOS) structure can be used for substrate 20.

In one embodiment, a passivation layer is formed on substrate 20 to protect or encapsulate drive circuitry 64. Thus, the passivation layer protects the integrity of drive circuitry 64 and prevents drive circuitry 64 from being attacked by dielectric liquid 52. Materials suitable for the passivation layer include an insulator or dielectric material such as silicon nitride, silicon carbide and/or silicon oxide.

Preferably, when the electrical signal is removed from electrode 60, reflective element 42 persists or holds second position 48 for some length of time. Thereafter, restoring forces of reflective element 42 including, for example, hinges 186 (Figure 2) and hinges 286 (Figure 3) pull or return reflective element 42 to first position 47.

Figure 5 illustrates another embodiment of actuation of micro-mirror device 10. Similar to the embodiment illustrated in Figure 4, reflective element 42 (including reflective elements 142 and 242) is moved between first position 47 and second position 48 by applying an electrical signal to electrode 60 formed on substrate 20 adjacent one end or edge of reflective element 42, as described above. As such, reflective element 42 is moved in a first direction.

However, in the embodiment illustrated in Figure 5, reflective element 42 is also moved in a second direction opposite the first direction. More specifically, reflective element 42 is moved between first position 47 and a third position 49 oriented at an angle to first position 47 by applying an electrical signal to an electrode 62 formed on substrate 20 adjacent an opposite end or edge of reflective element 42. As such, reflective element 42 is moved in the second direction opposite the first direction by application of an electrical signal to electrode 62.

Application of the electrical signal to electrode 62 generates an electric field between electrode 62 and reflective element 42 which causes movement of reflective element 42 between first position 47 and third position 49 in a manner similar to how reflective element 42 moves between first position 47 and second position 48, as described above. It is also within the scope of the present invention for reflective element 42 to move directly between second position 48 and third position 49 without stopping or pausing at first position 47.

Figure 6 illustrates another embodiment of actuation of micro-mirror device 10. In one embodiment, a conductive via 26 is formed in and extends through post 24. Conductive via 26 is electrically coupled to reflective element 42 and, more specifically, conductive material of reflective element 42. As such, reflective element 42 (including reflective elements 142 and 242) is moved between first position 47 and second position 48 by applying an electrical signal to electrode 60 and reflective element 42. More specifically, electrode 60 is energized to one polarity and the conductive material of reflective element 42 is energized to an opposite polarity.

Application of an electrical signal of one polarity to electrode 60 and an electrical signal of an opposite polarity to reflective element 42 generates an electric field between electrode 60 and reflective element 42 which causes movement of reflective element 42 between first position 47 and second position 48. Dielectric liquid 52 contributes to the movement of reflective element 42, as described above.

In another embodiment, reflective element 42 (including reflective elements 142 and 242) is moved between first position 48 and second position 49 by applying an electrical signal to reflective element 42. More specifically, the electrical signal is applied to conductive material of reflective element 42 by way of conductive via 26 through post 24. As such, application of an electrical signal to reflective element 42 generates an electric field which causes movement of reflective element 42 between first position 48 and second position 49. Dielectric liquid 52 contributes to the movement of reflective element 42, as described above.

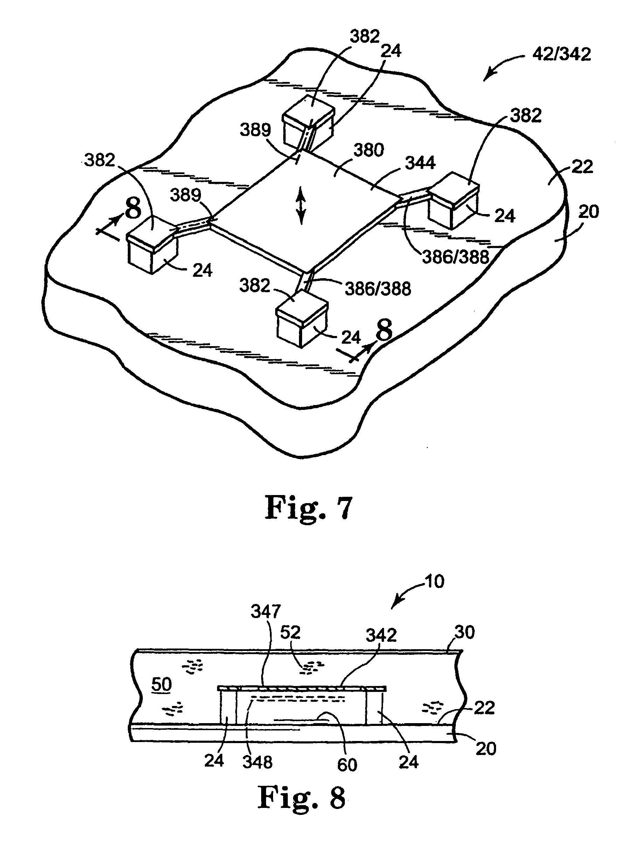

Figure 7 illustrates another embodiment of reflective element 42. Reflective element 342 has a reflective surface 344 and includes a substantially rectangular-shaped central portion 380 and a plurality of substantially rectangular-shaped portions 382. In one embodiment, reflective surface 344 is formed on central portion 380 and rectangular-shaped portions 382. Preferably, rectangular-shaped portions 382 are positioned at corners of central portion 380.

In one embodiment, hinges 386 extend between rectangular-shaped portions 382 and central portion 380. Hinges 386 extend from a side or edge of rectangular-shaped portions 382 to adjacent sides or edges of sides or edges of central portion 380. Preferably, central portion 380 is supported by hinges 386 along diagonal axes of symmetry. More specifically, central portion 380 is supported about axes that extend between opposite corners of central portion 380. As such, hinges 386 facilitate movement of reflective element 342 between a first position 347 and a second position 348, as described below (Figure 8). More specifically, hinges 386 facilitate movement of central portion 380 between first position 347 and second position 348 relative to rectangular-shaped portions 382.

In one embodiment, hinges 386 include flexure members 388 having longitudinal axes 389 oriented substantially parallel to reflective surface 344. Longitudinal axes 389 extend between opposite corners of and intersect at a center of central portion 380. As such, flexure members 388 bend along longitudinal axes 389 to accommodate movement of central portion 380 between first position 347 and second position 348 relative to rectangular-shaped portions 382.

In one embodiment, reflective element 342 is supported relative to substrate 20 by a plurality of posts 24 extending from surface 22 of substrate 20. More specifically, posts 24 support rectangular-shaped portions 382 of reflective element 342. As such, posts 24 are positioned at corners of central portion 380. Thus, central portion 380 of reflective element 342 is supported from posts 24 by hinges 386.

Figure 8 illustrates one embodiment of actuation of micro-mirror device 10 including reflective element 342. In one embodiment, reflective element 342 is actuated so as to move between first position 347 and second position 348 relative to substrate 20 and plate 30. Preferably, reflective element 342 moves in a direction substantially perpendicular to surface 22 of substrate 20. As such, first position 347 and second position 348 of reflective element 342 are both illustrated as being substantially horizontal and parallel to each other.

In one embodiment, reflective element 342 is moved between first position 347 and second position 348 by applying an electrical signal to electrode 60 formed on substrate 20. Preferably, electrode 60 is formed on substrate 20 so as to be located centrally under reflective element 342. Application of an electrical signal to electrode 60 generates an electric field between electrode 60 and reflective element 342 which causes movement of reflective element 342 between first position 347 and second position 348.

Preferably, when the electrical signal is removed from electrode 60, reflective element 342 persists or holds second position 348 for some length of time. Thereafter, restoring forces of reflective element 342 including, for example, hinges 386 pull or return reflective element 342 to first position 347.

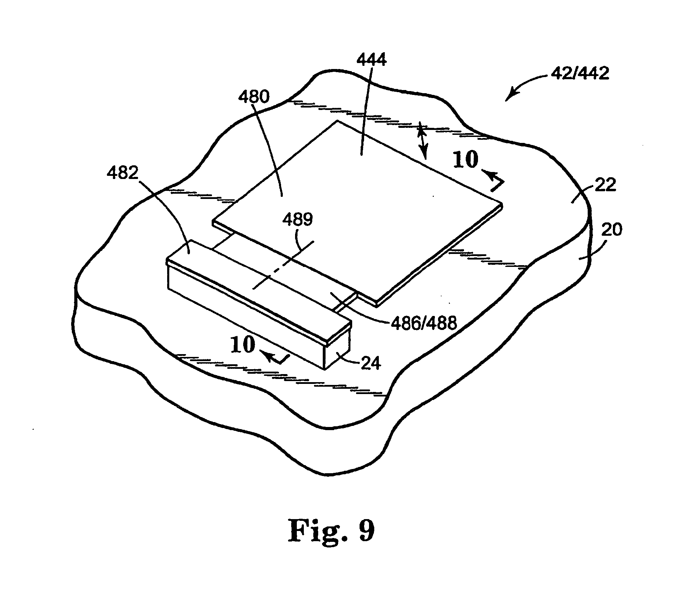

Figure 9 illustrates another embodiment of reflective element 42. Reflective element 442 has a reflective surface 444 and includes a first substantially rectangular-shaped portion 480 and a second substantially rectangular-shaped portion 482. In one embodiment, reflective surface 444 is formed on both rectangular-shaped portions 480 and 482. Second rectangular-shaped portion 482 is positioned along a side of first rectangular-shaped portion 480.

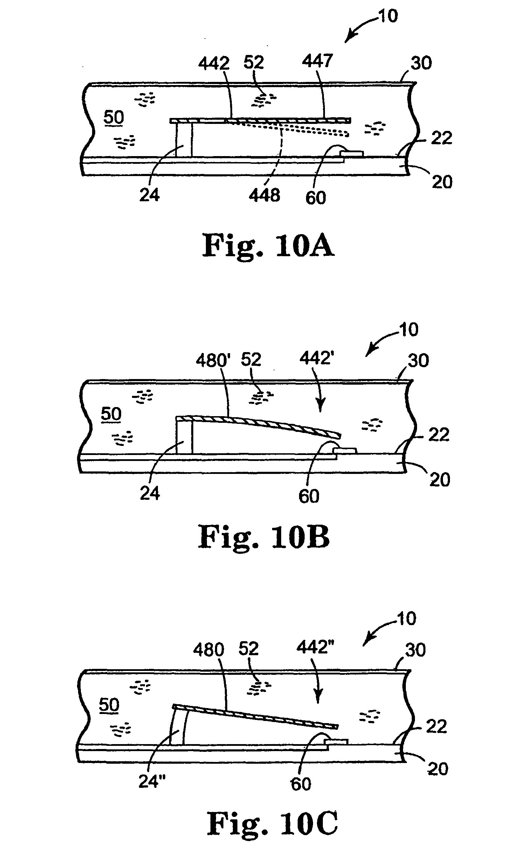

In one embodiment, a hinge 486 extends between rectangular-shaped portion 482 and rectangular-shaped portion 480. Hinge 486 extends from a side or edge of rectangular-shaped portion 482 to an adjacent side or edge of rectangular-shaped portion 480. As such, rectangular-shaped portion 480 is supported in a cantilever manner along one side or edge thereof. Thus, hinge 486 facilitates movement of reflective element 442 between a first position 447 and a second position 448 as described below (Figure 10). More specifically, hinge 486 facilitates movement of rectangular-shaped portion 480 between first position 447 and second position 448 relative to rectangular-shaped portion 482.

In one embodiment, hinge 486 includes a flexure member 488 having an axis 489 oriented substantially parallel to reflective surface 444. As such, flexure member 488 bends along axis 489 to accommodate movement of rectangular-shaped portion 480 between first position 447 and second position 448 relative to rectangular-shaped portion 482. While flexure member 488 is illustrated as being one member, it is within the scope of the present invention for flexure member 488 to include a plurality of spaced members.

In one embodiment, reflective element 442 is supported relative to substrate 20 by post 24 extending from surface 22 of substrate 20. More specifically, post 24 supports substantially rectangular-shaped portion 482 of reflective element 442. As such, post 24 is positioned to a side of rectangular-shaped portion 480. Thus, rectangular-shaped portion 480 of reflective element 442 is supported from post 24 by hinge 486. While post 24 is illustrated as being one post, it is within the scope of the present invention for post 24 to include a plurality of spaced posts. In addition, positioning of post 24 on a side of rectangular-shaped portion 480 includes positioning of post 24 at a corner of rectangular-shaped portion 480.

Figure 10A illustrates one embodiment of actuation of micro-mirror device 10 including reflective element 442. In one embodiment, reflective element 442 is actuated so as to move between first position 447 and second position 448 relative to substrate 20 and plate 30. Preferably, reflective element 442 moves in a direction toward surface 22 of substrate 20.

In one embodiment, reflective element 442 is moved between first position 447 and second position 448 by applying an electrical signal to electrode 60 formed on substrate 20. Preferably, electrode 60 is formed on substrate 20 adjacent an end or edge of reflective element 442. Application of an electrical signal to electrode 60 generates an electric field between electrode 60 and reflective element 442 which causes movement of reflective element 442 between first position 447 and second position 448.

Preferably, when the electrical signal is removed from electrode 60, reflective element 442 persists or holds second position 448 for some length of time. Thereafter, restoring forces of reflective element 442 including, for example, hinge 486 pulls or returns reflective element 442 to first position 447.

Figures 10B and 10C illustrate additional embodiments of actuation of micro-mirror device 10 including additional embodiments of reflective element 442. In the embodiment illustrated in Figure 10B, reflective element 442' includes a substantially rectangular-shaped portion 480' supported directly by post 24. Rectangular-shaped portion 480' is flexible and post 24 is substantially rigid such that rectangular-shaped portion 480' flexes during actuation. In the embodiment illustrated in Figure 10C, reflective element 442" includes substantially rectangular-shaped portion 480 supported directly by post 24". Rectangular-shaped portion 480 is substantially rigid and post 24" is flexible such that post 24" flexes during actuation. While substantially rectangular-shaped portion 480 (including rectangular-shaped portion 480') and post 24 (including post 24") are illustrated as separate members, it is within the scope of the present invention for rectangular-shaped portion 480 and post 24 to be integrally formed as one unitary member.

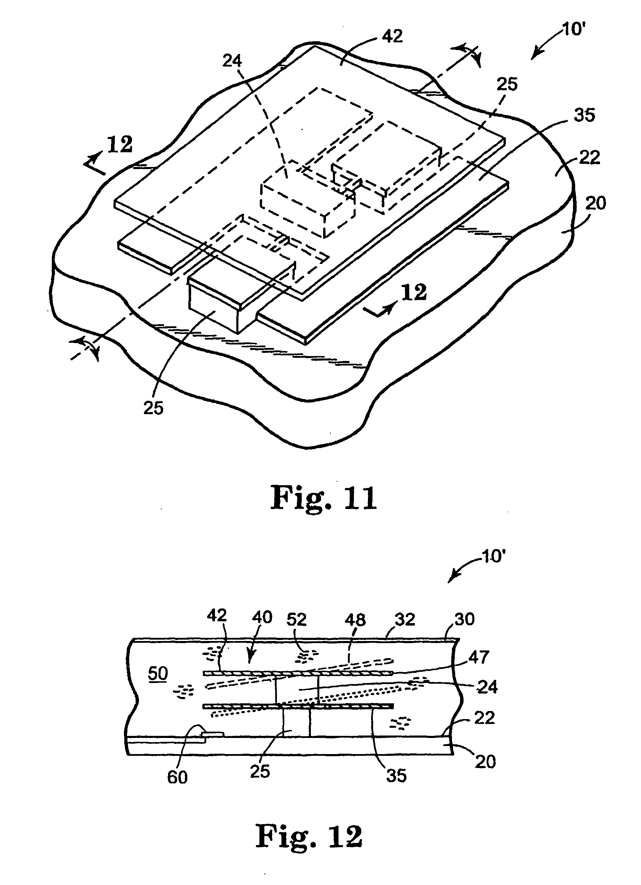

Figures 11 and 12 illustrate another embodiment of micro-mirror device 10. Micro-mirror device 10' is similar to micro-mirror device 10 and includes substrate 20, plate 30, and actuating element 40 with cavity 50 defined between substrate 20 and plate 30. As such, cavity 50 is filled with dielectric liquid 52, as described above. Micro-mirror device 10', however, includes a driver plate 35 interposed between substrate 20 and actuating element 40.

Preferably, plate 30 is transparent plate 32 and actuating element 40 is reflective element 42. In addition, reflective element 42 is supported relative to substrate 20 by post 24. Post 24, however, extends from driver plate 35. As such, in one embodiment, driver plate 35 is supported relative to substrate 20 by posts 25 extending from surface 22 of substrate 20.

Actuation of micro-mirror device 10' is similar to that of micro-mirror device 10, as described above, with the exception that both driver plate 35 and reflective element 42 are actuated. As such, driver plate 35 and reflective element 42 are both moved between first position 47 and second position 48 by applying an electrical signal to electrode 60 formed on substrate 20. Application of an electrical signal to electrode 60 generates an electric field between electrode 60 and driver plate 35 and/or reflective element 42 which causes movement of driver plate 35 and reflective element 42 between first position 47 and second position 48.

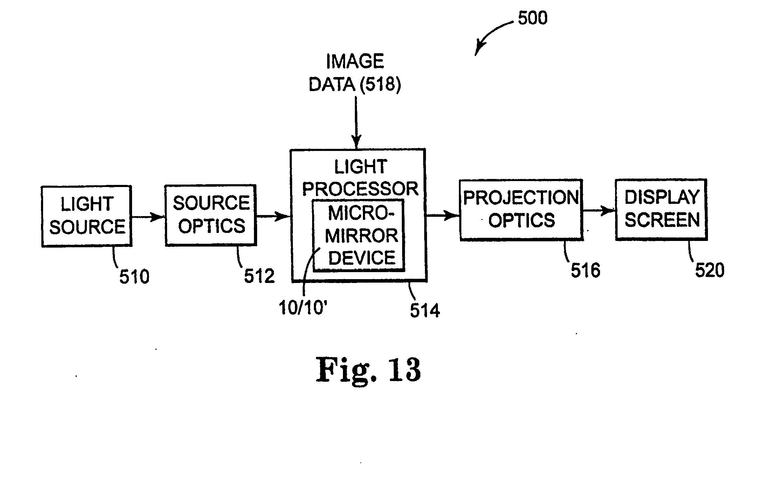

In one embodiment, as illustrated in Figure 13, micro-mirror device 10 (including micro-mirror device 10') is incorporated in a display system 500. Display system 500 includes a light source 510, source optics 512, a light processor or controller 514, and projection optics 516. Light processor 514 includes multiple micro-mirror devices 10 arranged in an array such that each micro-mirror device 10 constitutes one cell or pixel of the display. The array of micro-mirror devices 10 may be formed on a common substrate with separate cavities and/or a common cavity for the reflective elements of the multiple micro-mirror devices 10.

In one embodiment, light processor 514 receives image data 518 representing an image to be displayed. As such, light processor 514 controls the actuation of micro-mirror devices 10 and the modulation of light received from light source 510 based on image data 518. The modulated light is then projected to a viewer or onto a display screen 520.

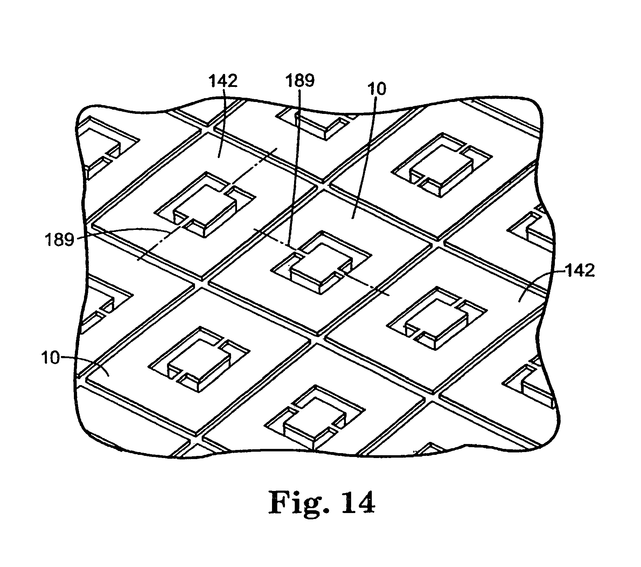

Figure 14 illustrates one embodiment of an array of micro-mirror devices 10. Micro-mirror devices 10 include reflective elements 142, as illustrated in Figure 2 and described above. Preferably, adjacent reflective elements 142 are rotated such that longitudinal axes 189 of one reflective element 142 extend in a first direction and longitudinal axes 189 of an adjacent reflective element 142 extend in a second direction oriented substantially perpendicular to the first direction.

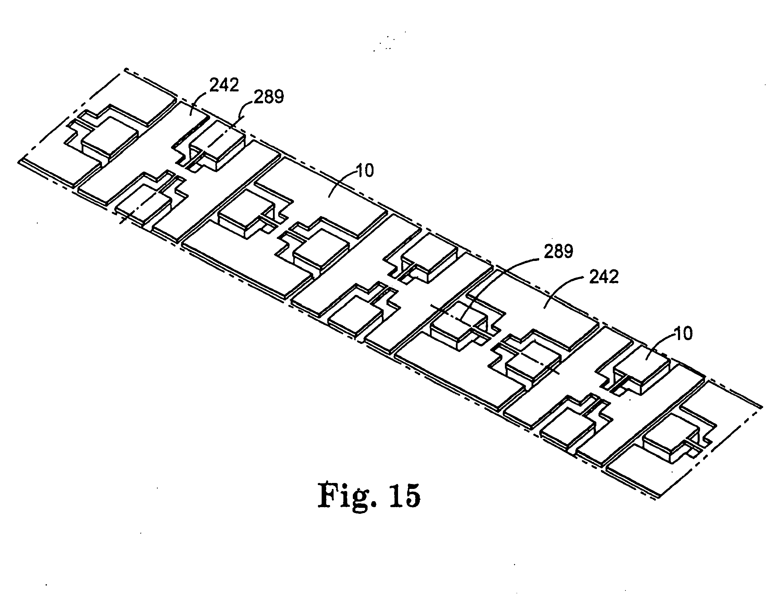

Figure 15 illustrates another embodiment of an array of micro-mirror devices 10. Micro-mirror devices 10 include reflective elements 242, as illustrated in Figure 3 and described above. Preferably, adjacent reflective elements 242 are rotated such that longitudinal axes 289 of one reflective element 242 extend in a first direction and longitudinal axes 289 of an adjacent reflective element 242 extend in a second direction oriented substantially perpendicular to the first direction. By rotating adjacent reflective elements 142 or 242 when forming an array of micro-mirror devices 10, fluidic cross coupling or cross-talk between adjacent reflective elements is avoided.

Although specific embodiments have been illustrated and described herein for purposes of description of the preferred embodiment, it will be appreciated by those of ordinary skill in the art that a wide variety of alternate and/or equivalent implementations calculated to achieve the same purposes may be substituted for the specific embodiments shown and described without departing from the scope of the present claims. Those with skill in the chemical, mechanical, electro-mechanical, electrical, and computer arts will readily appreciate that the present invention may be implemented in a very wide variety of embodiments.

Therefore, it is manifestly intended that this invention be limited only by the scope of the claims.

## Claims

1. An electrostatically actuated micro-mirror device (10/10'), comprising:
a substrate (20) having a surface (22);
a plate (30) spaced from and oriented substantially parallel to the surface of the substrate, the plate and the surface of the substrate defining a cavity (50) therebetween;
a dielectric liquid (52) disposed in the cavity;
a reflective element (42/142/242/342/442) interposed between the surface of the substrate and the plate, wherein the reflective element includes an electrically conductive material and is adapted to move between a first position and at least one second position; and **characterised in that**:
the reflective element is adapted to move between the first position and the at least one second position in response to application of an electrical signal to the conductive material; and
the dielectric liquid is responsive to the electrostatic field generated by the electrical signal such that the actuation force acting on the reflective element (42) is enhanced.

2. The device of claim 1, wherein the plate and the dielectric liquid are transparent.

3. The device of claim 1, wherein the reflective element is submerged in the dielectric liquid.

4. The device of claim 1, wherein the reflective element is positioned above the dielectric liquid.

5. The device of claim 1, wherein the at least one second position of the reflective element is oriented at an angle to the first position.

6. The device of claim 1, wherein the at least one second position of the reflective element is oriented substantially parallel to the first position.

7. The device of claim 1, further comprising:
at least one post (24) extending from the surface of the substrate and supporting the reflective element relative to the surface of the substrate.

8. The device of claim 7, further comprising:
at least one hinge (186/286/386/486) supporting the reflective element from the at least one post, wherein the at least one hinge is adapted to facilitate movement of the reflective element between the first position and the at least one second position.

9. The device of claim 7, further comprising:
a conductive via (26) extending through the at least one post and electrically coupled to the reflective element.

10. The device of claim 7, wherein the reflective element includes a substantially rectangular-shaped portion (180) having four contiguous side portions (181), wherein the at least one post is positioned within the four contiguous side portions.

11. The device of claim 7, wherein the reflective element includes a substantially H-shaped portion (280) having a pair of spaced leg portions (281) and a connecting portion (282) extending between the spaced leg portions, wherein the at least one post includes a pair of posts each positioned on opposite sides of the connecting portion between the spaced leg portions.

12. The device of claim 7, wherein the reflective element includes a substantially rectangular-shaped central portion (380) and a plurality of substantially rectangular-shaped portions (382) positioned at corners of the central portion, wherein the at least one post includes a plurality of posts each positioned at corners of the central portion.

13. The device of claim 7, wherein the reflective element includes a substantially rectangular-shaped portion (480), wherein the at least one post is positioned to a side of the rectangular-shaped portion.

14. The device of claim 1, further comprising:
a driver plate (35) interposed between the surface of the substrate and the reflective element, wherein the driver plate and the reflective element are adapted to move between the first position and the at least one second position.

15. The device of claim 1, further comprising:
at least one electrode (60/62) formed on the surface of the substrate adjacent an end of the reflective element,
wherein the reflective element is adapted to move in response to application of an electrical signal to the at least one electrode.

16. The device of claim 15, wherein the reflective element includes a conductive material, wherein the reflective element is adapted to move in response to application of an electrical signal to the at least one electrode and the conductive material.

17. The device of claim 1, wherein the dielectric liquid is adapted to increase an actuation force on the reflective element as generated by a given activation energy.

18. A method of forming an electrostatically actuated micro-mirror device (10/10'), the method comprising:
providing a substrate (20) having a surface (22);
orienting a plate (30) substantially parallel to the surface of the substrate and spacing the plate from the surface of the substrate, including defining a cavity (50) between the plate and the surface of the substrate;
disposing a dielectric liquid (52) in the cavity; and
interposing a reflective element (42/142/242/342/442) between the surface of the substrate and the plate,
wherein the reflective element includes an electrically conductive material and is adapted to move between a first position and at least one second position; and **characterised in that**:
the reflective element is adapted to move between the first position and the at least one second position in response to application of an electrical signal to the conductive material; and
the dielectric liquid is responsive to the electrostatic field generated by the electrical signal such that the actuation force acting on the reflective element (42) is enhanced.

## Patentansprüche

1. Eine elektrostatisch betätigte Mikrospiegelvorrichtung (10/10'), die folgende Merkmale aufweist:
ein Substrat (20) mit einer Oberfläche (22);
eine Platte (30), die von der Oberfläche des Substrats beabstandet und im Wesentlichen parallel zu derselben ausgerichtet ist, wobei die Platte und die Oberfläche des Substrats einen Hohlraum (50) zwischen denselben definieren;
eine dielektrische Flüssigkeit (52), die in dem Hohlraum angeordnet ist;
ein reflektierendes Element (42/142/242/342/442), das zwischen der Oberfläche des Substrats und der Platte angeordnet ist, wobei das reflektierende Element ein elektrisch leitfähiges Material umfasst und angepasst ist, um sich zwischen einer ersten Position und zumindest einer zweiten Position zu bewegen; und **dadurch gekennzeichnet ist, dass**:
das reflektierende Element angepasst ist, um sich zwischen der ersten Position und der zumindest einen zweiten Position zu bewegen, ansprechend auf das Anlegen eines elektrischen Signals an das leitfähige Material; und
die dielektrische Flüssigkeit auf das elektrostatische Feld anspricht, das durch das elektrische Signal erzeugt wird, derart, dass die Betätigungskraft, die auf das reflektierende Element (42) wirkt, verbessert wird.

2. Die Vorrichtung gemäß Anspruch 1, bei der die Platte und die dielektrische Flüssigkeit transparent sind.

3. Die Vorrichtung gemäß Anspruch 1, bei der das reflektierende Element in die dielektrische Flüssigkeit eingetaucht ist.

4. Die Vorrichtung gemäß Anspruch 1, bei der das reflektierende Element über der dielektrischen Flüssigkeit positioniert ist.

5. Die Vorrichtung gemäß Anspruch 1, bei der die zumindest eine zweite Position des reflektierenden Elements in einem Winkel zu der ersten Position ausgerichtet ist.

6. Die Vorrichtung gemäß Anspruch 1, bei der die zumindest eine zweite Position des reflektierenden Elements im Wesentlichen parallel zu der ersten Position ausgerichtet ist.

7. Die Vorrichtung gemäß Anspruch 1, die ferner folgende Merkmale aufweist:
zumindest eine Stütze (24), die sich von der Oberfläche des Substrats erstreckt und das reflektierende Element relativ zu der Oberfläche des Substrats trägt.

8. Die Vorrichtung gemäß Anspruch 7, die ferner folgendes Merkmal aufweist:
zumindest ein Gelenk (186/286/386/486), das das reflektierende Element von der zumindest einen Stütze trägt, wobei das zumindest eine Gelenk angepasst ist, um eine Bewegung des reflektierenden Elements zwischen der ersten Position und der zumindest einen Position zu ermöglichen.

9. Die Vorrichtung gemäß Anspruch 7, die ferner folgendes Merkmal aufweist:
ein leitfähiges Durchgangsloch (26), das sich durch die zumindest eine Stütze erstreckt und elektrisch mit dem reflektierenden Element gekoppelt ist.

10. Die Vorrichtung gemäß Anspruch 7, bei der das reflektierende Element einen im Wesentlichen rechteckig geformten Abschnitt (180) mit vier zusammenhängenden Seitenabschnitten (181) umfasst, wobei die zumindest eine Stütze innerhalb der vier zusammenhängenden Seitenabschnitte positioniert ist.

11. Die Vorrichtung gemäß Anspruch 7, bei der das reflektierende Element einen im Wesentlichen H-förmigen Abschnitt (280) umfasst, der ein Paar von beabstandeten Schenkelabschnitten (281) und einen Verbindungsabschnitt (282), der sich zwischen den beabstandeten Schenkelabschnitten erstreckt, aufweist, wobei die zumindest eine Stütze ein Paar aus Stützen umfasst, die jeweils an gegenüberliegenden Seiten des Verbindungsabschnitts zwischen den beabstandeten Schenkelabschnitten positioniert sind.

12. Die Vorrichtung gemäß Anspruch 7, bei der das reflektierende Element einen im Wesentlichen rechteckig geformten Mittelabschnitt (380) und eine Mehrzahl von im Wesentlichen rechteckig geformten Abschnitten (382) aufweist, die an Ecken des Mittelabschnitts positioniert sind, wobei die zumindest eine Stütze eine Mehrzahl von Stützen umfasst, die jeweils an Ecken des Mittelabschnitts positioniert sind.

13. Die Vorrichtung gemäß Anspruch 7, bei der das reflektierende Element einen im Wesentlichen rechteckig geformten Abschnitt (480) umfasst, wobei die zumindest eine Stütze an einer Seite des rechteckig geformten Abschnitts positioniert ist.

14. Die Vorrichtung gemäß Anspruch 1, die ferner folgende Merkmale aufweist:
eine Treiberplatte (35), die zwischen der Oberfläche des Substrats und dem reflektierenden Element positioniert ist, wobei die Treiberplatte und das reflektierende Element angepasst sind, um sich zwischen der ersten Position und der zumindest einen zweiten Position zu bewegen.

15. Die Vorrichtung gemäß Anspruch 1, die ferner folgende Merkmale aufweist:
zumindest eine Elektrode (60/62), die auf der Oberfläche des Substrats benachbart zu einem Ende des reflektierenden Elements gebildet ist,
wobei das reflektierende Element angepasst ist, um sich ansprechend auf das Anlegen eines elektrischen Signals an die zumindest eine Elektrode zu bewegen.

16. Die Vorrichtung gemäß Anspruch 15, bei der das reflektierende Element ein leitfähiges Material umfasst, wobei das reflektierende Element angepasst ist, um sich ansprechend auf das Anlegen eines elektrischen Signals an die zumindest eine Elektrode und das leitfähige Material zu bewegen.

17. Die Vorrichtung gemäß Anspruch 1, bei der die dielektrische Flüssigkeit angepasst ist, um eine Betätigungskraft auf das reflektierende Element zu erhöhen, wie sie durch eine gegebene Aktivierungsenergie erzeugt wird.

18. Ein Verfahren zum Bilden einer elektrostatisch betätigten Mikrospiegelvorrichtung (10/10'), wobei das Verfahren folgende Schritte aufweist:
Bereitstellen eines Substrats (20) mit einer Oberfläche (22);
Ausrichten einer Platte (30) im Wesentlichen parallel zu der Oberfläche des Substrats und Beabstanden der Platte von der Oberfläche des Substrats, was das Definieren eines Hohlraums (50) zwischen der Platte und der Oberfläche des Substrats umfasst;
Anordnen einer dielektrischen Flüssigkeit (52) in dem Hohlraum; und
Zwischenpositionieren eines reflektierenden Elements (42/142/242/342/442) zwischen der Oberfläche des Substrats und der Platte,
wobei das reflektierende Element ein elektrisch leitfähiges Material umfasst und angepasst ist, um sich zwischen einer ersten Position und zumindest einer zweiten Position zu bewegen; und **dadurch gekennzeichnet ist, dass**:
das reflektierende Element angepasst ist, um sich zwischen der ersten Position und der zumindest einen zweiten Position zu bewegen, ansprechend auf das Anlegen eines elektrischen Signals an das leitfähige Material; und
die dielektrische Flüssigkeit auf das elektrostatische Feld anspricht, das durch das elektrische Signal erzeugt wird, derart, dass die Betätigungskraft, die auf das reflektierende Element (42) wirkt, verbessert wird.

## Revendications

1. Dispositif à micro-miroir actionné électrostatiquement (10/10'), comprenant :
un substrat (20) ayant une surface (22) ;
une plaque (30) espacée de et orientée sensiblement parallèlement à la surface du substrat, la plaque et la surface du substrat définissant une cavité (50) entre celles-ci ;
un liquide diélectrique (52) disposé dans la cavité ;
un élément réfléchissant (42/142/242/342/442) interposé entre la surface du substrat et la plaque, dans lequel l'élément réfléchissant comprend un matériau électriquement conducteur et est adapté pour se déplacer entre une première position et au moins une deuxième position ; et **caractérisé en ce que** :
l'élément réfléchissant est adapté pour se déplacer entre la première position et l'au moins une deuxième position en réponse à l'application d'un signal électrique au matériau conducteur ; et
le liquide diélectrique est réactif au champ électrostatique généré par le signal électrique de sorte que la force d'actionnement exercée sur l'élément réfléchissant (42) soit augmentée.

2. Dispositif selon la revendication 1, dans lequel la plaque et le liquide diélectrique sont transparents.

3. Dispositif selon la revendication 1, dans lequel l'élément réfléchissant est immergé dans le liquide diélectrique.

4. Dispositif selon la revendication 1, dans lequel l'élément réfléchissant est positionné au-dessus du liquide diélectrique.

5. Dispositif selon la revendication 1, dans lequel l'au moins une deuxième position de l'élément réfléchissant est orientée à un angle par rapport à la première position.

6. Dispositif selon la revendication 1, dans lequel l'au moins une deuxième position de l'élément réfléchissant est orientée sensiblement parallèlement à la première position.

7. Dispositif selon la revendication 1, comprenant en outre :
au moins un montant (24) s'étendant depuis la surface du substrat et soutenant l'élément réfléchissant par rapport à la surface du substrat.

8. Dispositif selon la revendication 7, comprenant en outre :
au moins une articulation (186/286/386/496) soutenant l'élément réfléchissant depuis l'au moins un montant, dans lequel l'au moins une articulation est adaptée pour faciliter le déplacement de l'élément réfléchissant entre la première position et l'au moins une deuxième position.

9. Dispositif selon la revendication 7, comprenant en outre :
un passage conducteur (26) s'étendant à travers l'au moins un montant et étant électriquement couplé à l'élément réfléchissant.

10. Dispositif selon la revendication 7, dans lequel l'élément réfléchissant comprend une partie de forme sensiblement rectangulaire (180) ayant quatre parties latérales contiguës (181), dans lequel l'au moins un montant est positionné dans les quatre parties latérales contiguës.

11. Dispositif selon la revendication 7, dans lequel l'élément réfléchissant comprend une partie sensiblement en forme de H (280) ayant une paire de parties de patte espacées (281) et une partie de raccordement (282) s'étendant entre les parties de patte espacées, dans lequel l'au moins un montant comprend une paire de montants chacun étant positionné sur des côtés opposés de la partie de raccordement entre les parties de patte espacées.

12. Dispositif selon la revendication 7, dans lequel l'élément réfléchissant comprend une partie centrale de forme sensiblement rectangulaire (380) et une pluralité de parties de forme sensiblement rectangulaire (382) positionnées à des coins de la partie centrale, dans lequel l'au moins un montant comprend une pluralité de montants chacun étant positionné à des coins de la partie centrale.

13. Dispositif selon la revendication 7, dans lequel l'élément réfléchissant comprend une partie de forme sensiblement rectangulaire (480), dans lequel l'au moins un montant est positionné au niveau d'un côté de la partie de forme rectangulaire.

14. Dispositif selon la revendication 1, comprenant en outre :
une plaque d'entraînement (35) interposée entre la surface du substrat et l'élément réfléchissant, dans lequel la plaque d'entraînement et l'élément réfléchissant sont adaptés pour se déplacer entre la première position et l'au moins une deuxième position.

15. Dispositif selon la revendication 1, comprenant en outre :
au moins une électrode (60/62) formée sur la surface du substrat adjacente à une extrémité de l'élément réfléchissant,
dans lequel l'élément réfléchissant est adapté pour se déplacer en réponse à l'application d'un signal électrique à l'au moins une électrode.

16. Dispositif selon la revendication 15, dans lequel l'élément réfléchissant comprend un matériau conducteur, dans lequel l'élément réfléchissant est adapté pour se déplacer en réponse à l'application d'un signal électrique à l'au moins une électrode et au matériau conducteur.

17. Dispositif selon la revendication 1, dans lequel le liquide diélectrique est adapté pour augmenter une force d'actionnement sur l'élément réfléchissant générée par une énergie d'activation donnée.

18. Procédé de formation d'un dispositif à micro-miroir électrostatiquement actionné (10/10'), le procédé comprenant :
la fourniture d'un substrat (20) ayant une surface (22) ;
l'orientation d'une plaque (30) sensiblement parallèle à la surface du substrat et l'espacement de la plaque depuis la surface du substrat, comprenant la formation d'une cavité (50) entre la plaque et la surface du substrat ;
la disposition d'un liquide diélectrique (52) dans la cavité ; et
l'interposition d'un élément réfléchissant (42/142/242/342/442) entre la surface du substrat et la plaque,
dans lequel l'élément réfléchissant comprend un matériau électriquement conducteur et est adapté pour se déplacer entre une première position et au moins une deuxième position ; et **caractérisé en ce que** :
l'élément réfléchissant est adapté pour se déplacer entre la première position et l'au moins une deuxième position en réponse à l'application d'un signal électrique au matériau conducteur ; et
le liquide diélectrique est réactif au champ électrostatique généré par le signal électrique de sorte que la force d'actionnement exercée sur l'élément réfléchissant (42) soit augmentée.
